# EUROPÄISCHE PATENTSCHRIFT

(11) **EP 1 946 135 B1**
(45) Veröffentlichungstag und Bekanntmachung des Hinweises auf die Patenterteilung: **05.07.2017**
(21) Anmeldenummer: 06828893.5
(22) Anmeldetag: 31.10.2006
(51) Int. Cl.: G01R 33/02

(54) **SENSORANORDNUNG**
SENSOR ARRAY
DISPOSITIF DE DETECTION

(30) Priorität: 03.11.2005 DE 102005052906
(43) Veröffentlichungstag der Anmeldung: 23.07.2008
(73) Patentinhaber: MTS Sensor Technologie GmbH & Co. KG, 58515 Lüdenscheid (DE)
(72) Erfinder: KISKER, Erhard, 40627 Düsseldorf (DE)
(74) Vertreter: Cohausz, Helge B.
(86) Internationale Anmeldenummer: PCT/EP2006/010447
(87) Internationale Veröffentlichungsnummer: WO 2007/051589

(56) Entgegenhaltungen:
- US-A- 5 870 328
- LI Y F ET AL: "Torsion-dependent magnetoimpedance in FeCuNbSiB nanocrystalline wires with vanishing or transverse anisotropy" JOURNAL OF APPLIED PHYSICS, AMERICAN INSTITUTE OF PHYSICS. NEW YORK, US, Bd. 93, Nr. 12, 15. Juni 2003 (2003-06-15), Seiten 9839-9844, XP012058806 ISSN: 0021-8979
- BLANCO J M ET AL: "Influence of AC Magnetic Field Amplitude on the Surface Magnetoimpedance Tensor in Amorphous Wire With Helical Magnetic Anisotropy" IEEE TRANSACTIONS ON MAGNETICS, IEEE SERVICE CENTER, NEW YORK, NY, US, Bd. 40, Nr. 5, September 2004 (2004-09), Seiten 3368-3377, XP011118652 ISSN: 0018-9464

## Beschreibung

Die Erfindung betrifft eine Sensoranordnung, insbesondere zum Messen/Detektieren von Magnetfeldern und/oder Torsionen und/oder mechanischen Verspannungen. Die Erfindung betrifft weiterhin ein Verfahren zum Detektieren/Messen dieser physikalischen Größen.

Grundsätzlich sind im Stand der Technik Sensoren zum Detektieren und/oder Messen derartiger physikalischer Größen bekannt (siehe z.B. US5870328). Problematisch bei den bekannten Sensoranordnungen ist es, dass diese oftmals nicht hoch integrierbar (miniaturisierbar) und darüber hinaus störanfällig sind.

Aufgabe der Erfindung ist es, eine Sensoranordnung und ein Detektionsverfahren bzw. Messverfahren für Magnetfelder, Torsionen oder Zugkräfte oder mechanische Verformungen bereitzustellen, welches sich durch eine geringe Störanfälligkeit, hohe Sensitivität, Selektivität und hohe Integrierbarkeit auszeichnet.

Gelöst wird diese Aufgabe durch eine Sensoranordnung, gemäß Anspruch 1. Weiterhin wird die Aufgabe gelöst durch ein Verfahren gemäß Anspruch 16. Wesentlicher Kerngedanke der Erfindung ist es, ein Sensorsignal zur Verfügung zu stellen, hier eine messbare Spannung, deren Größe und/oder Verlauf/Form abhängig ist von den magnetischen Zuständen der vorgenannten Leiterabschnitte, wobei die magnetischen Zustände, also insbesondere die vorliegenden Magnetisierungen abhängig sind von äußeren Einwirkungen, wie z.B. Magnetfelder, Zugspannungen oder Torsionen, denen ein oder mehrere der genannten Leiterabschnitte ausgesetzt sind zum Zeitpunkt einer Erfassung der Messgröße, d.h. der vorgenannten Spannung.

Die Bereitstellung eines derartigen Spannungssignals geht auf einen Spintransport zurück, der von einem vorgenannten ersten Leiterabschnitt in wenigstens einen der zweiten Leiterabschnitte erfolgt.

Erreicht wird ein derartiger Spintransport durch eine magnetische Anregung in einem ersten Leiterabschnitt, die sich bis in den zweiten Leiterabschnitt fortsetzt, also dorthin transportiert wird und dort detektierbar ist. Diese Anregung erfolgt bevorzugt derart, dass eine dynamische insbesondere helikale Magnetisierung in einem ersten Leiterabschnitt erzeugt wird, was insbesondere derart erfolgen kann, dass eine Überlagerung eines externen Magnetfeldes, in welchem wenigstens der erste Leiterabschnitt angeordnet ist, mit einem Magnetfeld erfolgt, welches durch einen Strom in einem ersten Leiterabschnitt erzeugbar ist. So erzeugt der Strom im Wesentlichen ein dem Querschnitt der Geometrie der Leiteranordnung folgendes umlaufendes, insbesondere zirkulares Magnetfeld, wobei ein externes Magnetfeld bevorzugt eine Komponente in Richtung eines ersten Leiterabschnittes aufweist. Die Überlagerung bildet somit eine Magnetisierung in einem ersten Leiterabschnitt mit zumindest in Richtung dieses Leiterabschnittes insbesondere helikaler Komponente.

Ein äußeres externes Magnetfeld kann z.B. mit Hilfe einer Spulenanordnung oder durch das Streufeld eines permanent magnetisierten Materials, das sich in unmittelbarer Nähe eines ersten Leiterabschnittes befindet, erzeugt werden. Auch lokale Magnetfelder in beliebiger Richtung beeinflussen die gemessene Spannung, was ebenfalls technisch ausgenutzt werden kann.

Um hierbei eine Dynamik der insbesondere helikalen Magnetisierung zu erhalten kann dabei wenigstens eines der beiden überlagernden Magnetfelder zeitlich variabel sein, bevorzugt das Magnetfeld welches durch einen Strom im ersten Leiterabschnitt erzeugt wird. Dies ist durch einen zeitlich variablen Strom, z.B. einen (insbesondere sinusförmigen) Wechselstrom oder auch einen Strompuls, insbesondere beliebiger Form erreichbar.

So kann es in einer Ausführung vorgesehen sein, dass ein Strom in einem ersten Leiterabschnitt gebildet wird durch einen Spannungspuls, insbesondere rechteckigen oder trapezförmigen Spannungspuls, der über einen ersten Leiterabschnitt angelegt ist. Hierbei kann bevorzugt die Anstiegs- und/oder Abfallzeit einer Flanke eines Strompulses im Bereich von 1 bis 150 Nanosekunden, bevorzugt 5 bis 20 Nanosekunden, insbesondere 15 Nanosekunden liegen. Insbesondere diese längeren Anstiegszeiten der Flanken führen zu geringeren Oszillationen im gemessenen Spannungssignal über einem zweiten Leiterabschnitt, was insbesondere bei eine elektrischen Fehlanpassung bei der Einkopplung der anregenden Spannung in den ersten leiterabschnitt vorteilhaft ist. So wird die zeitliche Länge der Flanken des anregenden Strompulses bevorzugt so gewählt, dass Oszillationen im gemessenen Spannungssignal verringert, insbesondere vermieden werden.

Eine dynamische insbesondere helikale Magnetisierung im ersten Leiterabschnitt erzeugt ein "Aufrütteln" des Spinsystems und ein Verschwinden des eventuellen Domänenwand-Pinnings und erleichtert somit aufgrund der Dynamik einen Spintransport, der detektierbar ist, da sich hierdurch die Magnetisierung in einem zweiten Leiterabschnitt dynamisch ändert.

Bei allen Ausführungen der Erfindung ist die aufgrund des Spintransportes entstehende und detektierte Spannung, die über einem zweiten Leiterabschnitt abfällt, abhängig von den magnetischen Zuständen beider Leiterabschnitte, so dass bei vorgegebenem magnetischen Zustand einer der Leiterabschnitte mittels einer gemessenen Spannung auf den magnetischen Zustand eines anderen Leiterabschnittes geschlossen werden kann.

Ein besonders effektiver Spintransport bzw. entstehende Spannung bzw. Transport der Magnetisierung von einem ersten in einen zweiten Leiterabschnitt kann erreicht werden, wenn im zweiten Leiterabschnitt eine insbesondere helikale Anisotropie vorherrscht, insbesondere wenn die Anisotropie hinsichtlich ihrer räumlichen Ausgestaltung zumindest einer Komponente derjenigen räumlichen Ausgestaltung der erzeugten insbesondere helikalen Magnetisierung in einem ersten Leiterabschnitt entspricht.

So ist das gemessene Spannungssignal insbesondere abhängig von einer derartigen Anpassung und durch eine Änderung dieser Anpassung variabel. Die Spin-Flußstärke zwischen den Leiterabschnitten wird somit wesentlich durch deren magnetische Eigenschaften beeinflusst.

Da sowohl äußere externe Magnetfelder, als auch mechanische Deformationen und/oder Torsionen, denen ein Leiterabschnitt ausgesetzt wird, Einfluss nimmt auf die vorliegende Anpassung ergibt sich die Möglichkeit mittels der Messung der Spannung Rückschlüsse zu ziehen auf diese wirkenden physikalischen Größen, so dass eine erfindungsgemäße Anordnung der beschriebenen Art als Sensor für diese Größen verwendbar ist.

In bevorzugter und konstruktiv einfacher Ausgestaltung kann ein erster Leiterabschnitt gebildet sein zwischen einem ersten und zweiten elektrischen Kontakt auf der Leiteranordnung und ein zweiter Leiterabschnitt zwischen einem dritten und einem vierten elektrischen Kontakt auf der Leiteranordnung. Hierbei kann es weiterhin bevorzugt vorgesehen sein, dass ein erster und ein zweiter Leiterabschnitt keinen gemeinsamen Abschnitt aufweisen. Hierdurch wird eine besonders störungsfreie Vierpunkt-Messung ermöglich, insbesondere ohne dass ein Stromfluss bzw. eine Spannung in einem ersten Leiterabschnitt die gemessene Spannung über einem zweiten Leiterabschnitt unmittelbar beeinflusst.

Zwischen dem ersten und zweiten elektrischen Kontakt kann von außen eine insbesondere zeitlich variable Spannung angelegt werden, z.B. eine SinusSpannung oder eine rechteck- bzw. trapezförmige Spannung. Durch diese Spannung wird ein Stromfluss im ersten Leiterabschnitt erzeugt und so in Verbindung mit einem weiteren Magnetfeld eine insbesondere helikale Magnetisierung. Zwischen dem dritten und dem vierten Anschluss kann die gemessene Spannung abgegriffen werden, die einen Rückschluss auf die transportierte Magnetisierung zulässt.

Bei dieser Anordnung kann als Leiteranordnung z.B. ein Draht beliebigen Querschnittes, bevorzugt ein Mikrodraht oder ein dünner Streifen aus geeignetem Material gewählt werden. Hierbei können erster und zweite Leiterabschnitte elektrisch mittels desselben Materiales elektrisch verbunden sein.

In einer anderen Ausführung kann es auch vorgesehen sein, dass ein erster Leiterabschnitt elektrisch von einem zweiten Leiterabschnitt getrennt ist. Auch hierdurch wird eine unmittelbare galvanische Beeinflussung der Spannungen ausgeschlossen. Eine effektive Übertragung der Magnetisierung zwischen den Leiterabschnitten wird hier so verstanden, dass der erste Leiterabschnitt als elektromagnetischer insbesondere helikaler Sender arbeitet und das Signal vom zweiten Leiterabschnitt als insbesondere helikale, insbesondere angepasste Antenne empfangen wird.

Gemäß einer Ausführung der erfindungsgemäßen Sensoranordnung kann für eine effiziente Spindiffusion in das magnetische/magnetisierbare Material eines zweiten Leiterabschnittes dessen Torsionszustand entscheidend sein, da eine mechanische Tordierung eine insbesondere helikale Anisotropie erzeugen kann, insbesondere in Verbindung mit einem externen Magnetfeld, in welchem sich auch ein zweiter Leiterabschnitt befinden kann oder insbesondere in Verbindung mit speziellen Materialeigenschaften des für die Leiterabschnitte verwendeten Materiales, welches zu einer insbesondere helikalen Anisotropie bei einer Tordierung beitragen kann. So wurde festgestellt, dass eine Verdrillung bzw. Tordierung eines weichmagnetischen Streifens oder Drahtes eine insbesondere helikale magnetische Anisotropie erzeugt. Für die zwei entgegengesetzten Drehrichtungen ergeben sich unterschiedliche Schraubenrichtungen der insbesondere helikalen magnetischen Anisotropie.

So kann nach dem erfindungsgemäßen Verfahren bei einer vorgegebenen insbesondere helikalen Magnetisierung in einem ersten Leiterabschnitt über die messbare Spannung, die über einem zweiten Leiterabschnitt abfällt, ein Betrag und/oder eine Richtung einer Torsion eines zweiten Leiterabschnittes gemessen wird. Hierbei kann die insbesondere helikale Magnetisierung in einem ersten Leiterabschnitt durch Wahl des externen Magnetfeldes und eines Stromes, insbesondere Strompulses vorgegeben und insbesondere bekannt sein. Die erfindungsgemäße Anordnung eignet sich somit als Torsionssensor.

Dabei stellt infolge des steilen Stromimpulses ein erster Leiterabschnitt eine magnetische Anregungen in der ansteigenden und in der abfallenden Flanke zur Verfügung. Die insbesondere helikale magnetische Anisotropie in einem zweiten Leiterabschnitt wählt gemäß der obigen Ausführung die passende aus dem ersten Leiterabschnitt austretende Anregung aus, die z.B. zu unterschiedlichen Vorzeichen der gemessenen Spannungsimpulse bei entgegengesetzter insbesondere helikaler Anisotropie des zweiten Leiterabschnittes führt.

In einer weiteren Ausführung kann es auch vorgesehen sein, dass einem Leiterabschnitt, insbesondere einem zweiten Leiterabschnitt eine insbesondere helikale Anisotropie statisch aufgeprägt ist.

So kann z.B. die insbesondere helikale Anisotropie, insbesondere in einem zweiten Leiterabschnitt beim Herstellungsprozess des magnetischen Materials erzeugt werden. Sie kann z.B. fest eingeprägt werden durch geeignete Wärmebehandlung (Tempern) eines ggfs. verdrillten Leiterabschnittes mit/ohne Magnetfeld/Stromfluß. Anstelle der Verdrillung des Materials während des Temperns kann auch die Helizität von Domänenwänden durch Tempern ohne äußeres Magnetfeld eingefroren werden. Dies ermöglicht eine Automatisierung des Herstellungsprozesses und eventuell die Hochintegration der hier beschriebenen Sensoren, z.B. für Anwendungen in magnetischen Random-Access-Memories (M-RAMs).

Beispielsweise kann sich bei fest eingestellter insbesondere helikaler Anisotropie eines zweiten Leiterabschnittes die Kombination aus Impulsrichtung und Flankenrichtung und Magnetfeldrichtung die Möglichkeit erschließen, logische Zustände zu unterscheiden, wobei ein logischer Zustand durch das Vorhandensein eines Magnetfeldes oder dessen Größe oder dessen Richtung gegeben sein kann. Ist also, insbesondere in der Umgebung eines ersten Leiterabschnittes, ggfs in der Umgebung der gesamten Sensoranordnung ein externes Magnetfeld vorhanden (z.B. Erdmagnetfeld) so ist die gemessene Spannung über einem zweiten Leiterabschnitt eine andere als wenn kein externes Magnetfeld, oder ein Magnetfeld mit anderer Richtung/Größe vorhanden ist. Somit kann die Sensoranordnung, insbesondere bei einer hohen Integration, als Lesevorrichtung für magnetische Speicher eingesetzt werden, in denen ein Magnetfeld einen logischen Zustand beschreibt. Auch können durch Magnetfeld und angelegten Strompuls logische Zustände miteinander verknüpft werden.

Z.B. kann dies erreicht werden, wenn in der Umgebung eines Leiterabschnittes ein magnetisches/magnetisiertes Element, insbesondere ein Permanentmagnet oder ein in Remanenz befindliches Element angeordnet ist. Z.B. kann es sich auch um einen magnetisierbaren Plattenspeicher handeln, mit Bereichen, die unterschiedliche Magnetisierungen aufweisen, welche mittels eines erfindungsgemäßen Sensors abgefragt werden können, dadurch, dass ein probender "Lese"-Strompuls durch einen ersten Leiterabschnitt fließt und am zweiten Leiterabschnitt ein Spannungspuls abgegriffen wird, der das Ergebnis der Auslesung des entsprechenden Speicherbereiches repräsentiert.

Ebenso kann die Sensoranordnung auch selbst als auslesbares Speicherelement dienen, wenn von außen Einfluss genommen wird auf die insbesondere helikale Anisotropie im zweiten Leiterabschnitt. So können dann z.B. logische Zustände gespeichert und ausgelesen werden. Dies setzt voraus, dass die Sensoranordnung ein Mittel umfasst zur Änderung der insbesondere helikalen Anisotropie in einem zweiten Leiterabschnitt.

In einer Ausführung der Erfindung kann es vorgesehen sein, dass ein erster und ein zweiter Leiterabschnitt linear hintereinander angeordnet sind, wobei es möglich ist, mehrere zweite Leiterabschnitte vorzusehen, z.B. bei linearer Anordnung beidseitig eines ersten Leiterabschnittes.

In anderer Ausführung können ein erster und wenigstens ein zweiter Leiterabschnitt in einem Winkel zueinander, insbesondere in einem rechten Winkel zueinander angeordnet sind. Auch können zwei oder mehr zweite Leiterabschnitte linear hintereinander und in einem Winkel, insbesondere in einem rechten Winkel zu einem ersten Leiterabschnitt angeordnet sind. Grundsätzlich lassen sich die vorgenannten Ausführungen auch beliebig kombinieren.

Vorteilhaft bei mehreren zweiten Leiterabschnitten ist es, dass ein Spannungssignal aus einem zweiten Leiterabschnitt verwendet werden kann als Referenzsignal für ein Signal welches aus einem oder mehreren anderen zweiten Leiterabschnitten gewonnen wird. So können insbesondere-Störeffekte, wie Enflüsse durch unerwünschte Magnetfelder (Erdmagnetfeld) durch einen Referenzvergleich ausgeschlossen werden, da ein solches störendes Magnetfeld auch bzgl. einer Messung der Referenzspannung wirkt.

In einer weiteren alternativen oder auch kumulativen Ausgestaltung kann zwischen einem ersten und einem zweiten Leiterabschnitt ein weiterer Leiterabschnitt angeordnet ist, an den eine Steuerspannung angelegt/anlegbar ist, wobei die über einem zweiten Leiterabschnitt messbare Spannung abhängig ist von der Steuerspannung. Auf diese Weise wird ein magnetischer Schalter realisiert.

Z.B. kann zwischen zwei Leiterabschnitten ein zusätzliches Kontaktpaar angeordnet werden, um dort eine Spannung anzulegen, so dass ein Strom durch das entsprechende Leiterelement fließt. Die dadurch bewirkte Störung des bei Spannung 0 ungehinderten Spintransports beeinflusst die Größe des Spannungssignals in einem zweiten Leiterabschnitt.

Neben der Möglichkeit in einem ersten Leiterabschnitt einen gepulsten Strom fließen zu lassen durch Anlegen einer anregenden gepulsten Spannung, besteht auch die Möglichkeit eine periodische sinusförmige anregenden Spannung am ersten Leiterabschnitt anzulegen. Hierdurch ergibt sich auch bei der gemessenen Spannung, die über einen zweiten Leiterschnitt messbar ist ein periodischer sinusförmiger Verlauf, dessen Phasenlage bzgl. der anregenden Spannung variabel ist und von den magnetischen Zustanden in den Leiterabschnitten abhängt. Z.B. kann durch eine Torsion, welche einen magnetischen Zustand in einem zweiten Leiterabschnitt ändert, eine Änderung der Phasenlage bewirkt werden. So kann eine erfindungsgemäße Anordnung auch als Phasenschieber verwendet werden, wobei eine Änderung der magnetischen Zustände nicht nur durch eine Torsion bewirkbar ist, sondern durch alle zuvor beschriebenen Maßnahmen.

Als Materialien zur Bildung einer Leiteranordnung kommen z.B. weichmagnetische, insbesondere amorphe Materialien und insbesondere eisen- oder bevorzugt kobaltbasiertes Material zum Einsatz, die auch als metallische Gläser bezeichnet werden. Folgende Materialien können z.B. eingesetzt werden: Co 70/Si+B 23/Mn 5/Fe+Mo 2 oder CO 66/Si 15/ B 14/Fe 4/Ni 1. Auch andere magnetische Legierungen können zum Einsatz kommen.

Ein erfindungsgemäßer Sensor zeichnet sich zusammenfassend dadurch aus, dass mit ihm Zug oder eine Torsion in Betrag und Richtung gemessen werden können (a) oder bei eingeprägter Torsion (allgemein: eingeprägter insbesondere helikaler Anisotropie) ein Rückschluss auf ein den Sensor überfagerndes externes Magnetfeld in Betrag und Richtung gezogen werden kann (b). Die Betriebsweise b eignet sich insbesondere als empfindlicher Magnetfeld-Sensor.

Der Sensor zeichnet sich gegenüber anderen auf magnetischer Basis (magnetowiderstands- oder magnetoimpedanzbasiert) dadurch aus, dass die als Messsignal benutzte Spannung frei von systembedingtem Untergrund ist bzw. gegenüber auf dem inversen Wiedemann-Effekt beruhenden Magnetfeld- oder Zug/Torsionssensoren durch die Abwesenheit einer dort notwendigen Pickupspule.

Daher ist bei Benutzung mittels der Erfindung eine Sensorstruktur möglich, die einfacher in der Herstellung und hochintegrationsfähig ist. In Zusammenwirken mechanischer, auf das Sensormaterial einwirkender Größen wie Torsions- und/oder Zugspannung mit magnetischen Größen (überlagertes Magnetfeld) und elektrischen Betriebsgrößen wie der Strom durch einen ersten Leiterabschnitt in Richtung, Amplitude und Puls- bzw. Wellenform entsteht in einem zweiten Leiterabschnitt eine Spannung, die von diesen Größen reproduzierbar abhängt und die als Auslesegröße dient.

Die nachfolgenden Figuren zeigen bevorzugte Ausführungsbeispiele der Erfindung. Es zeigen:
- Figur 1:: einen erfindungsgemäßen Sensor in der Anwendung als Torsions-/Magnetfeldsensor in linearer Anordnung von erstem und zweitem Leiterabschnitt
- Figur 2:: einen erfindungsgemäßen Sensor in abgewinkelter Anordnung von erstem und zweitem Leiterabschnitt
- Figur 3:: einen erfindungsgemäßen Sensor mit zwei zweiten Leiterabschnitten, die in einem rechten Winkel zum ersten Leiterabschnitt angeordnet sind,
- Figur 4:: den zeitlichen Verlauf einer gemessenen Spannung bei zwei entgegengesetzten Torsionen von 15 Grad in Verbindung mit den anregenden bipolaren Strompulsen
- Figur 5:: den zeitlichen Verlauf einer gemessenen Spannung bei unipolaren Strompulsen und einer vorgegebenen Torsion
- Figuren 6-8:: die Abhängigkeit des gemessenen Spannungssignals von der zeitlichen Länge der Flanken der Strompulse
- Figur 9:: die Signalspannung bei festem Magnetfeld in Abhängigkeit der Torsion
- Figur 10:: die Signalspannungen in Abhängigkeit von Magnetfeld, Torsion und Strompulsrichtung
- Figur 11:: ein erfindungsgemäßer Sensor in Anwendung als Lesevorrichtung für magnetische Speicher
- Figur 12:: die Abhängigkeit eines zeitlichen Signalverlaufs mit/ohne magnetisiertem Material in der Umgebung eines ersten Leiterabschnittes
- Figur 13:: die Abhängigkeit der Phasenlage zwischen anregender und gemessener Spannung von der Torsion

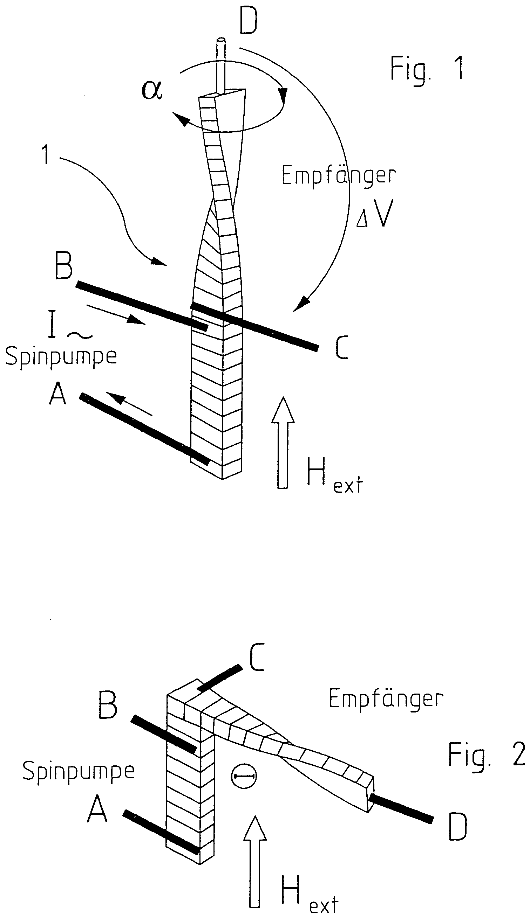

Die Figur 1 zeigt einen erfindungsgemäßen Sensor in prinzipieller Darstellung. Das wesentliche Element des Sensors kann ein dünner Streifen aus (weich)magnetischem Material sein. In einer Ausführung kann ein dünner, lateral auf einem Träger angebrachter Streifen mit einer Dicke z.B. kleiner als 100 Mikrometer oder ein Mikrodraht, in einer anderen Ausführung ein senkrecht zu einem Träger aufgebrachter zylindrischer Körper vorgesehen sein. Ebenso können dünne, z.B. aufgedampfte Schichten verwendet werden.

In der Figur 1 ist die erste Ausführung illustriert. Der Sensor ist funktionsmäßig in zwei Bereiche aufgeteilt. Ein z.B. homogener weichmagnetischer Streifen 1 wird durch Kontaktierung in zwei elektrische Bereiche geteilt, die sich zwischen Kontakten A,B und C,D befinden. Der Teil zwischen den Kontakten A und B bildet einen ersten Leiterabschnitt, der hier wegen seiner Funktion auch als "Spinpumpe" bezeichnet werden kann und der Teil zwischen C und D bildet einen zweiten Leiterabschnitt, auch als Empfänger bezeichnet.

Der Sensor wird z.B. von einer Halterungsplatine getragen. Die Platine kann unterhalb der Spinpumpe starr sein. Im Bereich des Empfängers muss eine Halterungsplatine genügend flexibel sein, um die Verdrillung zu ermöglichen. Falls nur kleine Drehmomente zur Verfügung stehen, kann der Empfänger auch freitragend zwischen den Kontaktierungen B und C angebracht sein, wobei die Zuleitung D z.B. mechanisch fest mit einer Halterung der Spinpumpe verbunden sein kann. Wegen einer Längenverkürzung beim Verdrillen kann es auch vorgesehen sein, dass die Position des Anschlusses D ortsvariabel angeordnet ist, insbesondere relativ zu einer Halterung der Spinpumpe.

Ein evtl. vorgesehener Träger kann aus elektrisch isolierendem Material bestehen. Er kann dazu dienen, den Sensor und alle elektrischen Anschlüsse mechanisch stabil zu tragen. Er ist mindestens so groß wie die Spinpumpe und hat die Eigenschaft, im Bereich unter der Spinpumpe starr zu sein und im Bereich unter dem Empfänger torsionselastisch zu sein. Die Anschlüsse des Empfängers sind Drähte, die durch geeignete Maßnahmen so flexibel gestaltet sind, dass sie die Torsion nicht behindern. Dies kann z.B. durch Einfügen einer kurzen Schlaufe in jeden der Drähte erfolgen.

Die Kontakte B und C sollen sich bevorzugt nicht berühren, um ein echte Vierpunktmessung zu ermöglichen.

Das Charakteristische dieses Sensors ist, daß die Spannung ΔV sowohl vom magnetischen Zustand der Spinpumpe als auch von demjenigen des Empfängers abhängt. Der magnetische Zustand der Spinpumpe wird für das Messprinzip entscheidend durch das Zusammenspiel der Richtung des Stromimpulses I und abfallender oder ansteigender Flanke und einem auf die Spinpumpe einwirkenden äußeren Magnetfeld Hₑₓₜ beeinflusst. Der magnetische Zustand des Empfängers wird in dieser Ausführung wesentlich durch dessen mechanische Verdrillung beeinflusst.

Da der Empfänger zwischen C und D nicht vom Strom I durchflossen wird, kann (bei Annahme der idealen Vierpunkt-Messmethode) eine Spannung ΔV nur dann auftreten, wenn sich zwischen den Kontakten C und D ein Generator mit einer elektromotorischen Kraft befindet. Hier beruht der Generator auf einem Prinzip, das aus einem dynamischen Spintransport aus der Spinpumpe in den Empfänger eine Spannung generiert.

Die Figur 1 skizziert das Prinzip der Erfindung. Allerdings ist es nicht notwendig, dass sich der Empfänger in linearer Anordnung zur Spinpumpe befindet. Gleichermaßen ist eine um einen Winkel θ gewinkelt Anordnung zwischen Spinpumpe und Empfänger möglich, wie es Figur 2 zeigt. Hervorgegangen ist diese Anordnung aus einem flächenhaften magnetischen dünnen Streifen. Wesentlich ist in dieser Ausführung, dass Spinpumpe und Empfänger elektrisch ohne Unterbrechung ineinander übergehen.

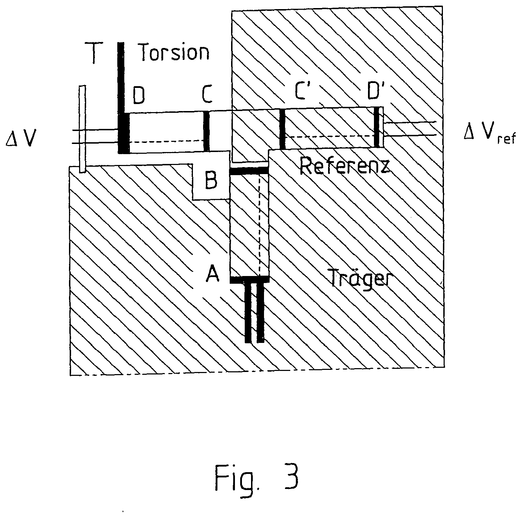

Die Spinpumpe kann auch mehrere Empfänger versorgen, die unabhängig voneinander verdrillt werden können, wie es Figur 3 zeigt. Dies ist vorteilhaft zur Kompensation des Einflusses eines äußeren Magnetfeldes. Hier wird wieder zwischen den Kontakten A und B die anregende Spannung in die Spinpumpe eingekoppelt. Gemessen wird zum einen zwischen D und C sowie zum anderen zwischen D' und C', wobei letztere Kontaktierung die Messung eines Referenzsignal ermöglicht. Hierbei sind Spinpumpe und Referenzempfänger auf einem starren Träger angeordnet, der Empfänger hingehen ist flexibel und verdrillbar aufgehängt. Hierbei weist auch der Referenzempfänger eine insbesondere helikale Anisotropie auf.

Die Spannung ΔV hängt nicht nur vom Torsionswinkel ab, sondern auch von einem äußeren Magnetfeld (Erdfeld, andere Störfelder), welches das zur Funktion notwendige Magnetfeld überlagert. Diese unerwünschte Eigenschaft lässt sich durch die besonderen Eigenschaften des Detektionsprinzips vorteilhaft beseitigen. Die Spinpumpe sendet ihr Signal nicht nur in die Richtung mit Bezug auf Figur 1 oberhalb der Spinpumpe eingezeichneten Empfängers aus, sondern auch nach unten. D.h., ein zweiter Empfänger kann auch symmetrisch zur Spinpumpe nach unten angebracht sein, oder wie in Figur 3 in einer T- Anordnung. Auch eine Doppel-T -Anordnung mit vier Empfängern ist möglich, ebenso Anordnungen mit noch mehr Empfängern.

Abmessungen des magnetischen Streifens in der linearen Ausführung Figur 1 sind ca. 10 mm x 1 mm x 30um. Stromfluß peak-peak ca. 100 mA, Spannung ΔV ca. 50 mV.

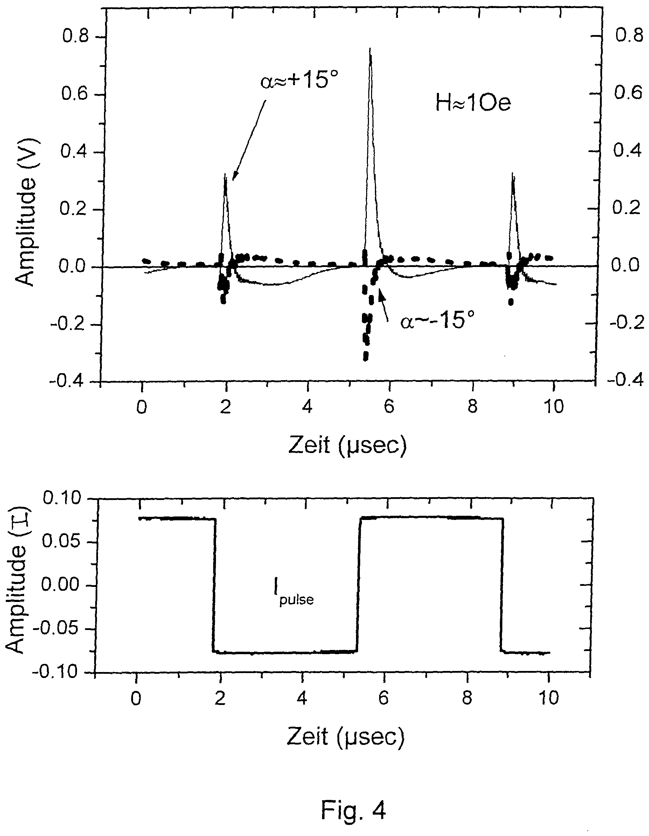

Ein Pulsgenerator kann z.B. eine periodische Impulsfolge erzeugen zur Einkopplung in die Spinpumpe. Die Figur 4 zeigt unten einen typischen anregenden bipolaren Puls. Das gemessene Spannungssignal ΔV (Figur 4 oben) ist ebenso bipolar und beträgt z.B. nach Verstärkung bis ±800 mV. Erkennbar ist hier, dass sich gemessene Spannungspeaks ergeben, die zeitlich bei den Flanken der anregenden Strompulse lokalisiert sind. Erkennbar ist weiterhin, dass sich bei einer Verdrillung im Uhrzeigersinn um ca. 15 Grad ein größeres gemessenen Spannungssignal ergibt als bei einer Messung mit Verdrillung um 15 Grad entgegen dem Uhrzeigersinn. Auch weist das Spannungssignal unterschiedliche Polaritäten auf.

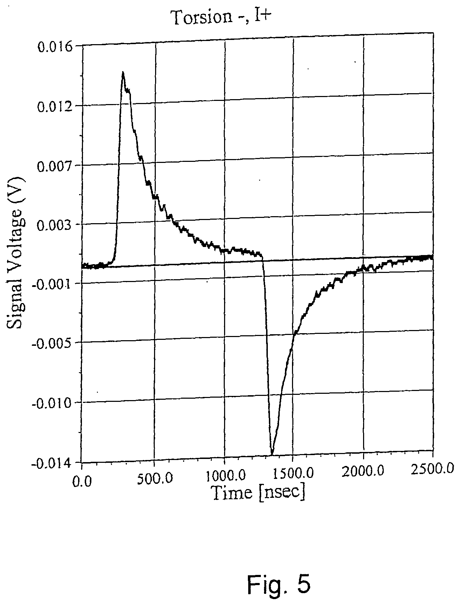

Demgegenüber zeigt die Figur 5 einen gemessenen Spannungsverlauf bei festem externen Magnetfeld und einer unipolaren Pulsfolge. Wiederum ergeben sich an den Flanken des anregenden Pulses ausgezeichnete gemessene Spannungspulse, nun mit unterschiedlicher Polarität.

Nach einer Verstärkung der gemessenen Spannung kann diese z.B. gleichgerichtet werden und dient als Messgröße für den Drehwinkel bei der Torsion. Die Kompensation gegen Schwankungen des Umgebungsmagnetfeldes kann durch Vergleich mit einem Referenzsignal, z.B. einer Subtraktion eines Referenzsignals ΔVref von ΔV oder durch elektronische Division von ΔV durch ΔVref, entweder analog oder digital nach Digitalisierung der Signale erfolgen, wenn z.B. in der Anordnung nach Figur 3 gemessen wird.

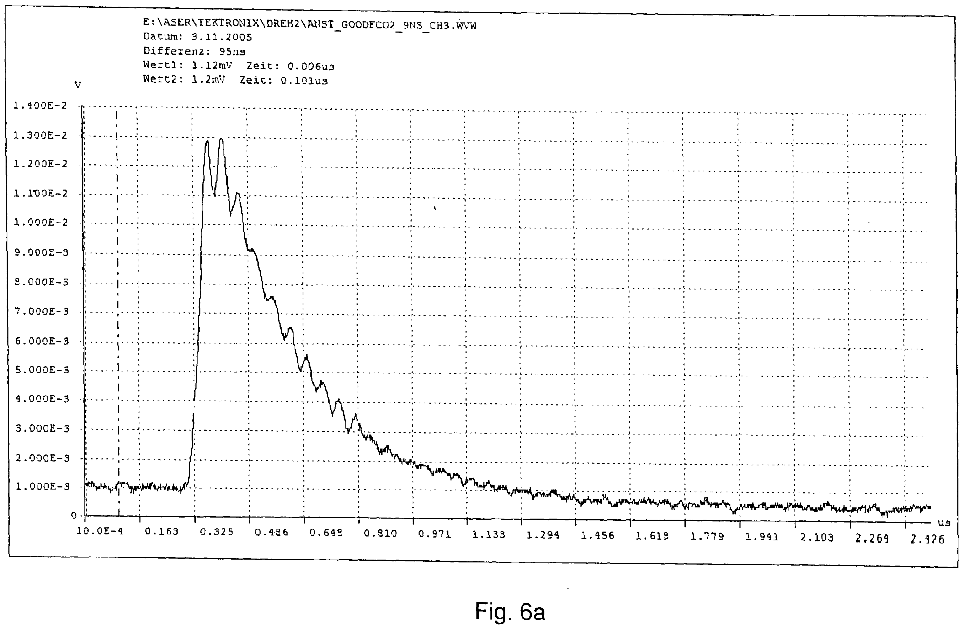

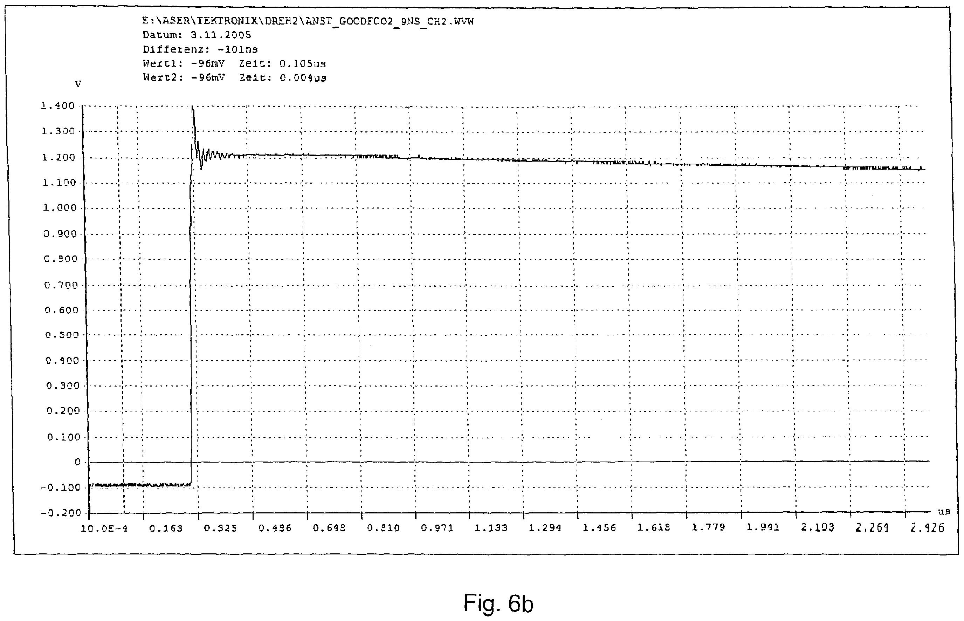

Figur 6b zeigt einen anregenden Spannungspuls zum Betrieb der Spinpumpe mit einer Flankensteilheit von ca. 9 Nanosekunden. Möglicherweise aufgrund nicht optimaler elektrischer Anpassung bei der Einkopplung der Spannungspulse in die Spinpumpe kommt es beim gemessenen Spannungssignal im Empfänger (Figur 6a) zu deutlichen Oszillationen, welche die Qualität der Messung beeinflussen.

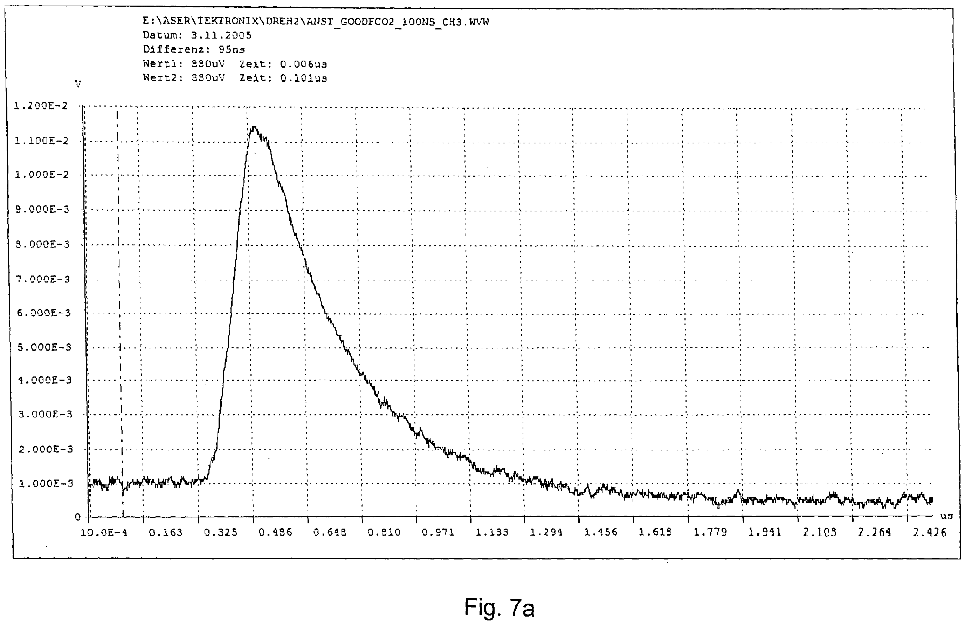

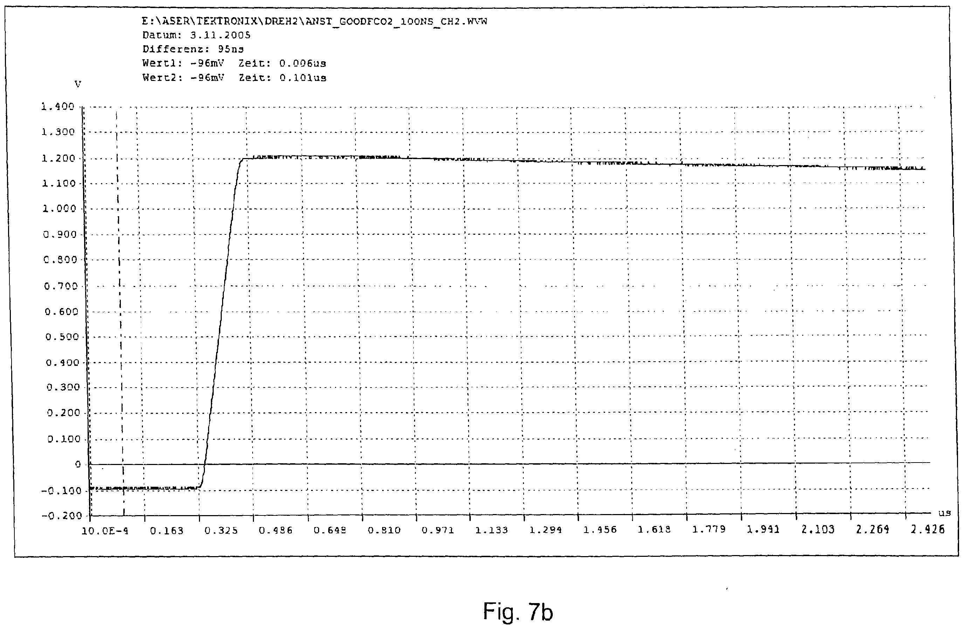

Demgegenüber zeigt die Figur 7b einen anregenden Puls mit einer Flankensteilheit von ca. 100 Nanosekunden. Deutlich sind im gemessenen Spannungssignal der Figur 7a die Überschwinger minimiert, ohne signifikant an Signalstärke zu verlieren.

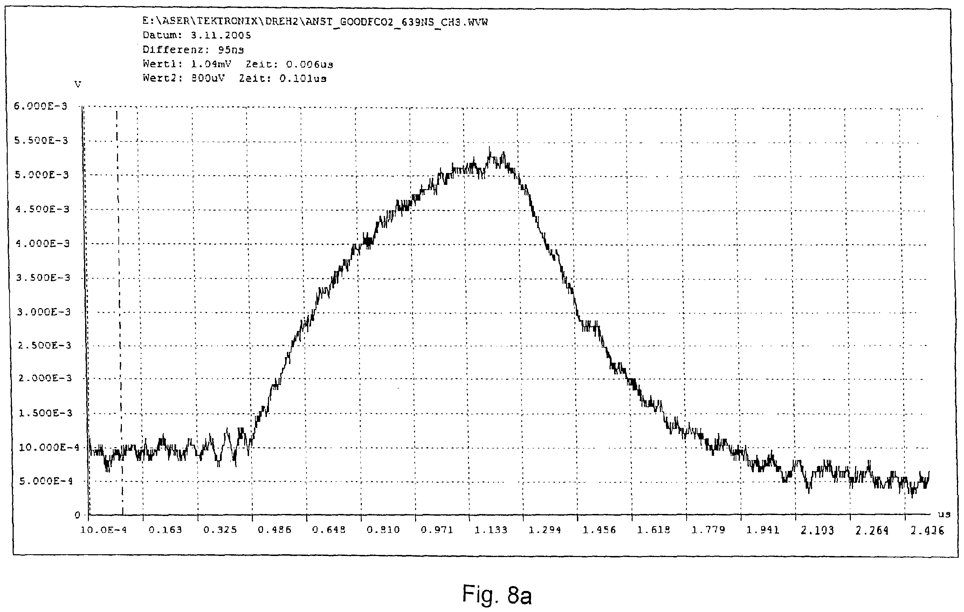

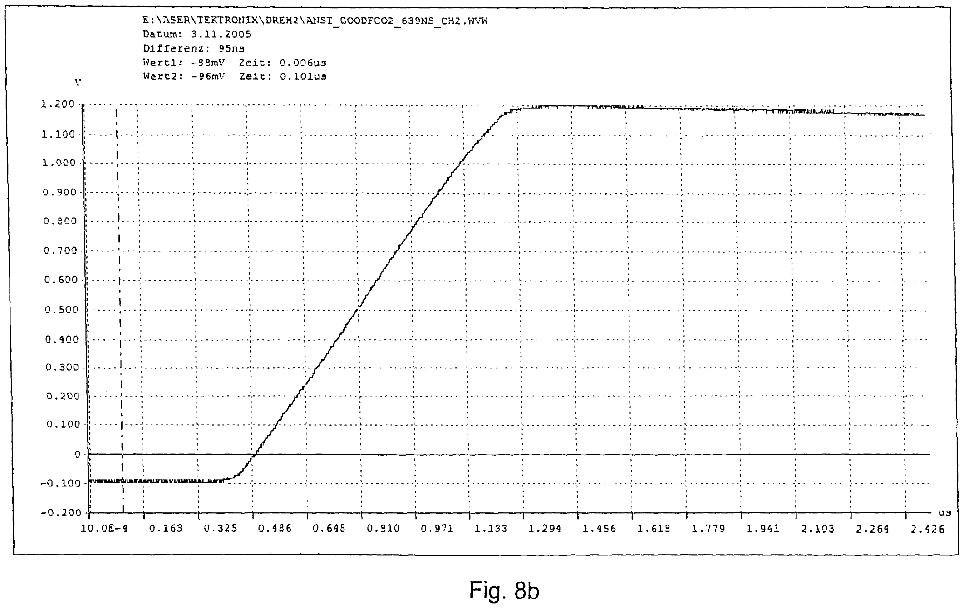

Erst bei einer weiteren Verlängerung der Flankenanstiegszeit auf ca. 639 Nanosekunden, wie es Figur 8b zeigt, ist ein Amplitudenverlust im gemessenen Signal der Figur 8a zu verzeichnen. Es wird daher Ziel sein, eine Flankenanstiegs-/- abfallzeit der Strompulse durch die Spinpumpe zu wählen, die optimal hinsichtlich des Signals abgestimmt ist und hier bevorzugt im Bereich von 5 bis 200 Nanosekunden liegt.

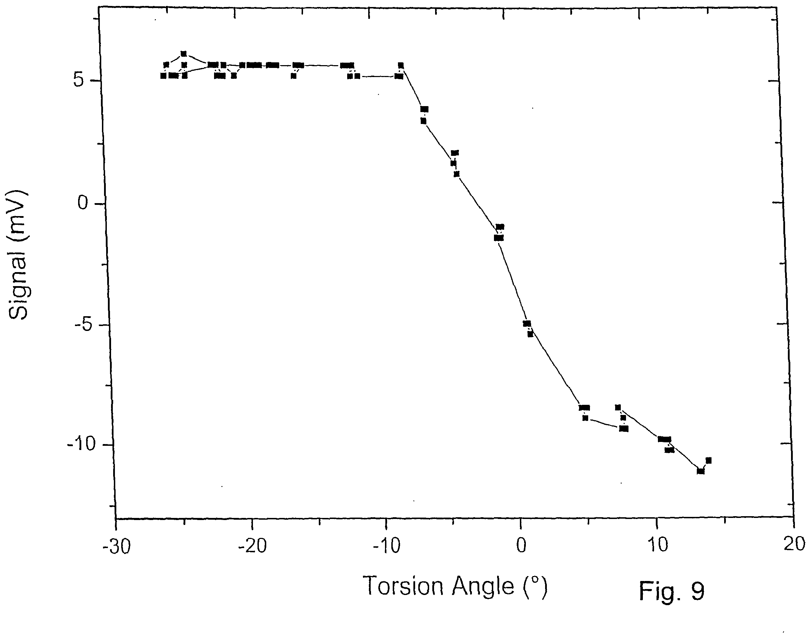

Figur 9 zeigt eine Messkurve, bei der bei einem konstanten externen Magnetfeld die Abhängigkeit der gemessenen Spannung gegenüber dem Torsionswinkel wiedergegeben ist. So wird ersichtlich, dass mittels einer erfindungsgemäßen Sensoranordnung ein Torsionswinkelsensor realisierbar ist.

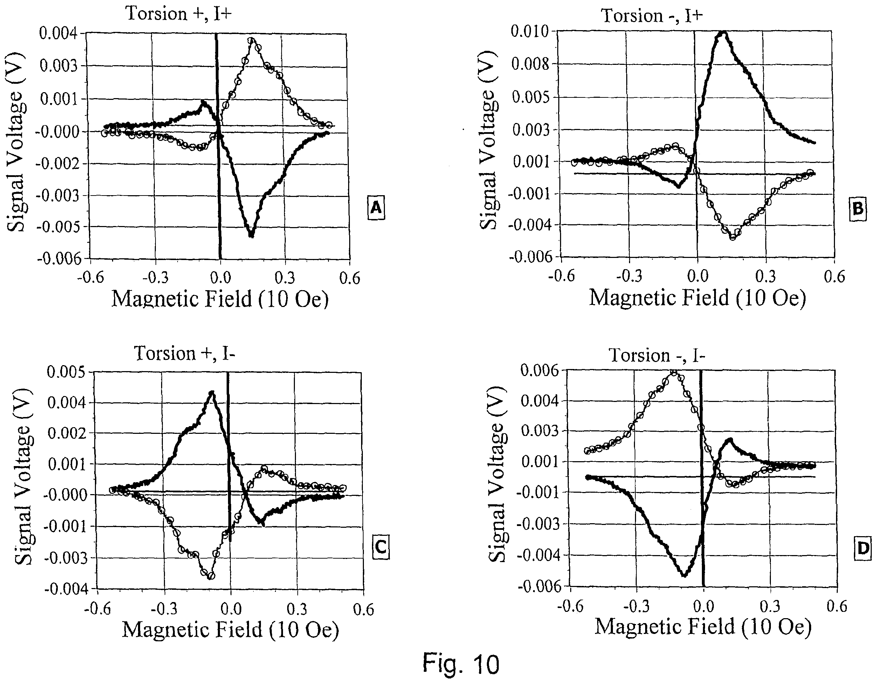

Die Figur 10 zeigt in mehreren Graphen die charakteristische Abhängigkeit des gemessenen Spannungssignals sowohl vom angelegten externen Magnetfeld als auch von einer Torsion und der Richtung des Strompulses im ersten Leiterabschnitt. Erkennbar ist zwischen den Graphen A und B, dass bei einer Änderung der Torsionsrichtung sich das in Abhängigkeit des Magnetfeldes gemessene Spannungssignal hinsichtlich seines Verlaufes im Wesentlichen umkehrt. Die gestrichelten Kurven zeigen den Spannungsverlauf bei der jeweils anderen Flanke.

Bei gleicher Torsion und geänderter Stromrichtung zeigen die Graphen A und C bzw. B und D eine Spiegelung des Signales an Abzisse und Ordinate. Insbesondere die Abhängigkeit des Signaleverlaufes von dem äußeren Magnetfeld eröffnet dabei die Anwendung als Magnetfeldsensor, z.B. in magnetischen Speicheranordnungen.

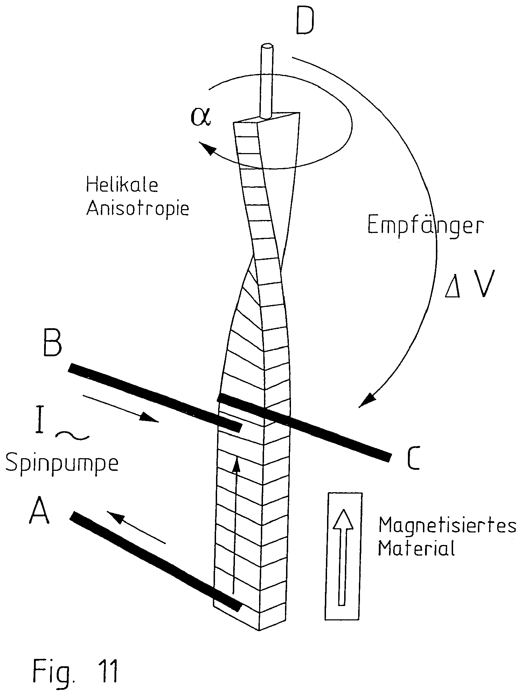

Eine derartige Anwendung ist im Prinzip in der Figur 11 dargestellt. Der grundsätzliche Aufbau ist wie in Figur 1, wobei nun der obere verdrillte Teil des Empfängers eine statische insbesondere helikale Anisotropie verdeutlichen soll, die diesem Leiterabschnitt aufgeprägt ist. In der Nähe der Spinpumpe ist ein magnetisiertes Material angeordnet, dessen Magnetfeldstärke oder Feldrichtung oder dessen grundsätzliche Existenz oder Nicht-Existenz in der Umgebung der Spinpumpe bzw. des ganzen Sensors das gemessene Signal beeinflusst.

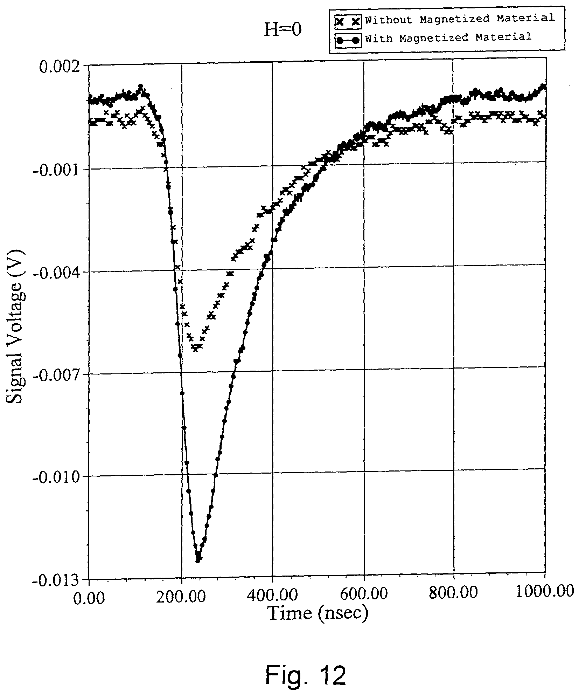

Zu dieser grundsätzlichen Anordnung zeigt die Figur 12 einen Spannungsverlauf am Empfänger einmal (fette Linie) bei anwesendem lokalen externen Magnetfeld und einmal (dünne Linie) bei abwesendem lokalen externen Magnetfeld. So wird ersichtlich, dass die Anordnung nach Figur 11 eine Lesevorrichtung für magnetische Speicher bilden kann. Je nachdem ob eine solche Lesevorrichtung gegenüber einem lokalen externen Magnetfeld angeordnet ist oder nicht bzw. ob sich Richtung oder Betrag des Feldes ändert können so logische Informationen gelesen werden, die im Magnetfeld verschlüsselt sind. Deutlich ist hier erkennbar, dass sich das gemessene Spannungssignal hier um den Faktor 2 unterscheidet und eine deutliche Diskriminierung der Existenz des externen Feldes zulässt. So kann z.B. eine Auslesung des magnetischen Zustandes remanent magnetisierter Datenbits mit Hilfe des hier beschriebenen Magnetfeldsensors anstelle anderer Prinzipien erfolgen.

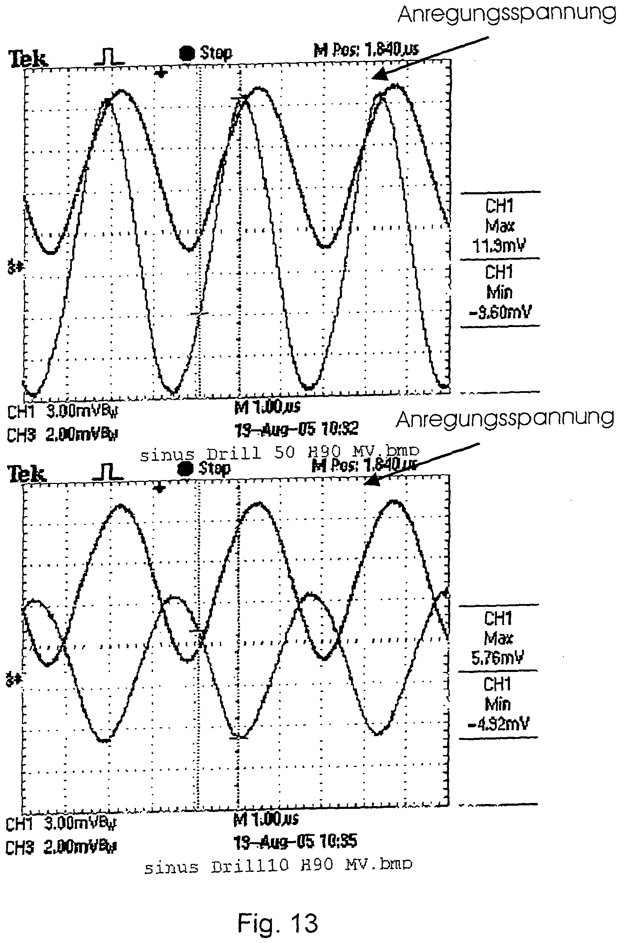

Figur 13 zeigt einen Signalverlauf zwischen anregender und gemessener Spannung von Spinpumpe bzw. Empfänger bei einer sinusförmigen Anregung. Hier ist erkennbar, dass sich die Phasenlage der Spannungen zueinander in Abhängigkeit einer Torsion des Empfängers ändert. So kann diese Anordnung gemäß Figur 1 auch als Phasenschieber eingesetzt werden. Gegenüber einer Torsion von ca. -50 Grad führt eine Torsion von ca. +10 Grad zu einer Phasenänderung von beinahe 180 Grad.

Weitere mögliche Anwendungen ergeben sich z.B. bei der Auslesung der Höhe einer rastenden Spitze über einer Probe (Raster-Kraftmikroskop) anstelle der bisher üblichen optischen Höhenbestimmung.

Ebenso kann ein Drehmomentschlüssel realisiert werden bei dem eine Messung der Verdrillung einer das Drehmoment übertragenden Stange erfolgt, die den Schlüsselkopf mit dem Hebel verbindet.

## Patentansprüche

1. Sensoranordnung, insbesondere zum Messen/Detektieren von Magnetfeldern und/oder Torsionen und/oder mechanischen Spannungen, **dadurch gekennzeichnet, dass** sie eine magnetisierbare/magnetische, insbesondere weichmagnetische elektrisch leitende Leiteranordnung umfasst, wobei die Leiteranordnung einen ersten Leiterabschnitt aufweist, in welchem eine dynamische, insbesondere helikale Magnetisierung erzeugbar ist, und wenigstens einen zweiten Leiterabschnitt aufweist, in welchem eine insbesondere helikale Anisotropie erzeugt oder erzeugbar ist, wobei eine Magnetisierung von einem ersten in einen zweiten Leiterabschnitt transportierbar und mittels einer über einem zweiten Leiterabschnitt aufgrund des Magnetisierungstransportes erzeugten Spannung detektierbar ist.

2. Sensoranordnung nach Anspruch 1, **dadurch gekennzeichnet, dass** in einem ersten Leiterabschnitt eine dynamische, insbesondere helikale Magnetisierung mittels eines durch den Leiterabschnitt laufenden zeitlich variablen Stromes erzeugbar ist, der ein variables Magnetfeld erzeugt, welches mit einem externen Magnetfeld überlagert ist.

3. Sensoranordnung nach einem der vorherigen Ansprüche, **dadurch gekennzeichnet, dass** ein erster Leiterabschnitt gebildet ist zwischen einem ersten und zweiten elektrischen Kontakt auf der Leiteranordnung und ein zweiter Leiterabschnitt zwischen einem dritten und einem vierten elektrischen Kontakt auf der Leiteranordnung, insbesondere wobei ein erster und ein zweiter Leiterabschnitt keinen gemeinsamen Abschnitt aufweisen.

4. Sensoranordnung nach einem der vorherigen Ansprüche, **dadurch gekennzeichnet, dass** ein erster Leiterabschnitt elektrisch von einem zweiten Leiterabschnitt getrennt ist.

5. Sensoranordnung nach einem der vorherigen Ansprüche, **dadurch gekennzeichnet, dass** eine insbesondere helikale Anisotropie in einem zweiten Leiterabschnitt erzeugbar ist durch eine Torsion eines zweiten Leiterabschnittes.

6. Sensoranordnung nach einem der vorherigen Ansprüche, **dadurch gekennzeichnet, dass** einem Leiterabschnitt, insbesondere einem zweiten Leiterabschnitt eine insbesondere helikale Anisotropie statisch aufgeprägt ist.

7. Sensoranordnung nach einem der vorherigen Ansprüche, **dadurch gekennzeichnet, dass** in der Umgebung eines Leiterabschnittes ein magnetisches/magnetisiertes Element, insbesondere ein Permanentmagnet oder ein in Remanenz befindliches Element angeordnet ist.

8. Sensoranordnung nach einem der vorherigen Ansprüche, **dadurch gekennzeichnet, dass** ein erster und ein zweiter Leiterabschnitt linear hintereinander angeordnet sind.

9. Sensoranordnung nach einem der vorherigen Ansprüche, **dadurch gekennzeichnet, dass** ein erster und ein zweiter Leiterabschnitt in einem Winkel zueinander, insbesondere in einem rechten Winkel zueinander angeordnet sind.

10. Sensoranordnung nach einem der vorherigen Ansprüche, **dadurch gekennzeichnet, dass** zwei zweite Leiterabschnitte linear hintereinander und in einem Winkel, insbesondere in einem rechten Winkel zu einem ersten Leiterabschnitt angeordnet sind.

11. Sensoranordnung nach einem der vorherigen Ansprüche, **dadurch gekennzeichnet, dass** zwischen einem ersten und einem zweiten Leiterabschnitt ein weiterer Leiterabschnitt angeordnet ist, an den eine Steuerspannung angelegt/anlegbar ist, wobei die über einem zweiten Leiterabschnitt messbare Spannung abhängig ist von der Steuerspannung.

12. Sensoranordnung nach einem der vorherigen Ansprüche, **dadurch gekennzeichnet, dass** Anstiegs- und/oder Abfallzeit einer Flanke eines Strompulses in einem ersten Leiterabschnitt im Bereich von 1 bis 150 Nanosekunden, bevorzugt 5 bis 20 Nanosekunden, insbesondere 15 Nanosekunden liegt.

13. Sensoranordnung nach einem der vorherigen Ansprüche, **dadurch gekennzeichnet, dass** ein erster Leiterabschnitt auf einem starren Trägerelement angeordnet ist, insbesondere wobei ein zweiter Leiterabschnitt auf einem flexiblen Träger angeordnet ist.

14. Sensoranordnung nach einem der vorherigen Ansprüche, **dadurch gekennzeichnet, dass** eine magnetische Leiteranordnung gebildet wird durch ein amorphes weichmagnetisches Material, insbesondere eisen- oder bevorzugt kobaltbasiertes Material.

15. Verwendung einer Sensoranordnung nach einem der vorherigen Ansprüche als Daten-Speicherelement und/oder als Auslesevorrichtung für magnetische Datenspeicher und/oder als Schaltelement und/oder als Torsionsmesser.

16. Verfahren zum Messen/Detektieren von Magnetfeldern und/oder Torsionen und/oder mechanischer Spannungen, insbesondere mit einem Sensor nach einem der vorherigen Ansprüche 1 bis 14, **dadurch gekennzeichnet, dass** in einem ersten Leiterabschnitt einer magnetisierbaren/magnetischen, insbesondere weichmagnetischen elektrisch leitenden Leiteranordnung eine dynamische, insbesondere helikale Magnetisierung erzeugt wird und in wenigstens einem zweiten Leiterabschnitt eine insbesondere helikale Anisotropie erzeugt oder erzeugbar ist, wobei eine Magnetisierung von einem ersten in einen zweiten Leiterabschnitt transportiert und mittels einer über einem zweiten Leiterabschnitt aufgrund des Magnetisierungstransports erzeugten Spannung detektiert wird.

17. Verfahren nach Anspruch 16, **dadurch gekennzeichnet, dass** bei einer vorgegebenen, insbesondere helikalen Anisotropie in wenigstens einem der zweiten Leiterabschnitte über die messbare Spannung ein externes Magnetfeld detektiert wird, welchem wenigstens einer der Leiterabschnitte, insbesondere ein erster Leiterabschnitt zum Zeitpunkt der Messung ausgesetzt ist.

18. Verfahren nach Anspruch 16, **dadurch gekennzeichnet, dass** bei einer vorgegebenen dynamischen, insbesondere helikalen Magnetisierung in einem ersten Leiterabschnitt über die messbare Spannung ein Betrag und/oder eine Richtung einer Torsion eines zweiten Leiterabschnittes gemessen wird.

## Claims

1. Sensor arrangement, in particular for measuring/detecting magnetic fields and/or torsions and/or mechanical stresses, **characterized in that** the said sensor arrangement comprises a magnetizable/magnetic, in particular soft-magnetic, electrically conductive conductor arrangement, wherein the conductor arrangement has a first conductor section in which a dynamic, in particular helical, magnetization can be generated, and has at least one second conductor section in which an, in particular helical, anisotropy is generated or can be generated, wherein a magnetization can be transported from a first conductor section to a second conductor section and can be detected by means of a voltage which is generated by means of a second conductor section on account of the magnetization transportation.

2. Sensor arrangement according to Claim 1, **characterized in that** a dynamic, in particular helical, magnetization can be generated in a first conductor section by means of a current which runs through the conductor section and is variable over time and generates a variable magnetic field which is superimposed by an external magnetic field.

3. Sensor arrangement according to one of the preceding claims, **characterized in that** a first conductor section is formed between a first and a second electrical contact on the conductor arrangement, and a second conductor section is formed between a third and a fourth electrical contact on the conductor arrangement, in particular wherein a first and a second conductor section do not have a common section.

4. Sensor arrangement according to one of the preceding claims, **characterized in that** a first conductor section is electrically isolated from a second conductor section.

5. Sensor arrangement according to one of the preceding claims, **characterized in that** an, in particular helical, anisotropy can be generated in a second conductor section by a torsion of a second conductor section.

6. Sensor arrangement according to one of the preceding claims, **characterized in that** an, in particular helical, anisotropy is statically impressed on a conductor section, in particular a second conductor section.

7. Sensor arrangement according to one of the preceding claims, **characterized in that** a magnetic/magnetized element, in particular a permanent magnet or an element which is in remanence, is arranged in the area surrounding a conductor section.

8. Sensor arrangement according to one of the preceding claims, **characterized in that** a first and a second conductor section are arranged linearly one behind the other.

9. Sensor arrangement according to one of the preceding claims, **characterized in that** a first and a second conductor section are arranged at an angle in relation to one another, in particular at a right angle in relation to one another.

10. Sensor arrangement according to one of the preceding claims, **characterized in that** two second conductor sections are arranged linearly one behind the other and at an angle, in particular at a right angle, in relation to a first conductor section.

11. Sensor arrangement according to one of the preceding claims, **characterized in that** a further conductor section is arranged between a first and a second conductor section, a control voltage being applied/applicable to the said further conductor section, wherein the voltage which can be measured across a second conductor section is dependent on the control voltage.

12. Sensor arrangement according to one of the preceding claims, **characterized in that** rise and/or fall time of an edge of a current pulse in a first conductor section lies in the range of from 1 to 150 nanoseconds, preferably 5 to 20 nanoseconds, in particular in the region of 15 nanoseconds.

13. Sensor arrangement according to one of the preceding claims, **characterized in that** a first conductor section is arranged on a rigid carrier element, in particular wherein a second conductor section is arranged on a flexible support.

14. Sensor arrangement according to one of the preceding claims, **characterized in that** a magnetic conductor arrangement is formed by an amorphous soft-magnetic material, in particular iron- or preferably cobalt-based material.

15. Use of a sensor arrangement according to one of the preceding claims as a data storage element and/or as a reading apparatus for magnetic data stores and/or as a switching element and/or as a torsion meter.

16. Method for measuring/detecting magnetic fields and/or torsions and/or mechanical stresses, in particular comprising a sensor according to one of the preceding Claims 1 to 14, **characterized in that** a dynamic, in particular helical, magnetization is generated in a first conductor section of a magnetizable/magnetic, in particular soft-magnetic, electrically conductive conductor arrangement, and an, in particular helical, anisotropy is generated or can be generated in at least a second conductor section, wherein a magnetization is transported from a first conductor section to a second conductor section and is detected by means of a voltage which is generated across a second conductor section on account of the magnetization transport.

17. Method according to Claim 16, **characterized in that** an external magnetic field to which at least one of the conductor sections, in particular a first conductor section, is exposed at the time of measurement is detected in the case of a prespecified, in particular helical, anisotropy in at least one of the second conductor sections by means of the measurable voltage.

18. Method according to Claim 16, **characterized in that** a magnitude and/or a direction of a torsion of a second conductor section is measured by means of the measurable voltage in the case of a prespecified dynamic, in particular helical, magnetization in a first conductor section.

## Revendications

1. Dispositif capteur, notamment destiné à mesurer/détecter des champs magnétiques et/ou des torsions et/ou des tensions mécaniques, **caractérisé en ce qu'**il comprend un dispositif conducteur magnétisable/magnétique, notamment magnétique doux, électriquement conducteur, dans lequel le dispositif conducteur comporte une première section conductrice dans laquelle une magnétisation dynamique, notamment hélicoïdale, peut être générée, et au moins une deuxième section conductrice dans laquelle une anisotropie, notamment hélicoïdale est générée ou peut être générée, dans lequel une magnétisation peut être transportée d'une première à une deuxième section conductrice et peut être détectée au moyen d'une tension générée sur une deuxième section conductrice du fait du transport de magnétisation.

2. Dispositif capteur selon la revendication 1, **caractérisé en ce qu'**une magnétisation dynamique, notamment hélicoïdale, peut être générée dans une première section conductrice au moyen d'un courant variable dans le temps passant à travers la section conductrice, lequel courant génère un champ magnétique variable qui peut être superposé à un champ magnétique externe.

3. Dispositif capteur selon l'une quelconque des revendications précédentes, **caractérisé en ce qu'**une première section conductrice est formée entre des premier et deuxième contacts électriques sur le dispositif conducteur et **en ce qu'**une deuxième section conductrice est formée entre des troisième et quatrième contacts électriques sur le dispositif conducteur, et notamment, dans lequel des première et deuxième sections conductrices ne comportent aucune section commune.

4. Dispositif capteur selon l'une quelconque des revendications précédentes, **caractérisé en ce qu'**une première section conductrice est électriquement séparée d'une deuxième section conductrice.

5. Dispositif capteur selon l'une quelconque des revendications précédentes, **caractérisé en ce qu'**une anisotropie, notamment hélicoïdale, peut être générée dans une deuxième section conductrice par une torsion d'une deuxième section conductrice.

6. Dispositif capteur selon l'une quelconque des revendications précédentes, **caractérisé en ce qu'**une anisotropie, notamment hélicoïdale, est appliquée de manière statique à une section conductrice, notamment à une deuxième section conductrice.

7. Dispositif capteur selon l'une quelconque des revendications précédentes, **caractérisé en ce qu'**un élément magnétique/magnétisé, notamment un aimant permanent ou un élément se trouvant en rémanence, est disposé dans l'environnement d'une section conductrice.

8. Dispositif capteur selon l'une quelconque des revendications précédentes, **caractérisé en ce que** des première et deuxième sections conductrices sont disposées linéairement l'une derrière l'autre.

9. Dispositif capteur selon l'une quelconque des revendications précédentes, **caractérisé en ce que** des première et deuxième sections conductrices sont disposées en formant un certain angle l'une par rapport à l'autre, notamment en formant un angle droit l'une par rapport à l'autre.

10. Dispositif capteur selon l'une quelconque des revendications précédentes, **caractérisé en ce que** deux deuxièmes sections conductrices sont disposées linéairement l'une derrière l'autre en formant un certain angle, notamment en formant un angle droit par rapport à une première section conductrice.

11. Dispositif capteur selon l'une quelconque des revendications précédentes, **caractérisé en ce qu'**une autre section conductrice est disposée entre des première et deuxième sections conductrices, sur laquelle est appliquée/peut être appliquée une tension de commande, dans lequel la tension pouvant être mesurée sur une deuxième section conductrice dépend de la tension de commande.

12. Dispositif capteur selon l'une quelconque des revendications précédentes, **caractérisé en ce que** le temps de montée et/ou de descente d'un front d'une impulsion de courant dans une première section conductrice se situe dans la plage de 1 à 150 nanosecondes, de préférence, de 5 à 20 nanosecondes, et est notamment de 15 nanosecondes.

13. Dispositif capteur selon l'une quelconque des revendications précédentes, **caractérisé en ce qu'**une première section conductrice est disposée sur un élément de support rigide, notamment dans lequel une deuxième section conductrice est disposée sur un support flexible.

14. Dispositif capteur selon l'une quelconque des revendications précédentes, **caractérisé en ce qu'**un dispositif conducteur magnétique est formé au moyen d'un matériau magnétique doux amorphe, notamment un matériau à base de fer ou de préférence à base de cobalt.

15. Utilisation d'un dispositif capteur selon l'une quelconque des revendications précédentes en tant qu'élément de stockage de données et/ou en tant que dispositif de lecture destiné à une mémoire de données magnétique et/ou en tant qu'élément de commutation et/ou en tant que dispositif de mesure de torsion.

16. Procédé mesurer/détecter des champs magnétiques et/ou de torsions et/ou de tensions mécaniques, comportant notamment un capteur selon l'une quelconque des revendications 1 à 14, **caractérisé en ce qu'**une magnétisation dynamique, notamment hélicoïdale, est générée dans une première section conductrice d'un dispositif conducteur magnétisable/magnétique, notamment magnétique doux, électriquement conducteur, et **en ce qu'**au moins une anisotropie, notamment hélicoïdale, est générée ou peut être générée, dans au moins une deuxième section conductrice, dans lequel une magnétisation est transportée d'une première à une deuxième section conductrice et est détectée au moyen d'une tension générée sur une deuxième section conductrice du fait du transport de magnétisation.

17. Procédé selon la revendication 16, **caractérisé en ce qu'**un champ magnétique externe est détecté dans le cas d'une anisotropie prédéterminée, notamment hélicoïdale, dans au moins l'une des deuxièmes sections conductrices par l'intermédiaire de la tension pouvant être mesurée, lequel champ magnétique externe est exposé à l'une des sections conductrices, notamment à une première section conductrice, à l'instant de la mesure.

18. Procédé selon la revendication 16, **caractérisé en ce que**, lors d'une magnétisation dynamique prédéterminée, notamment hélicoïdale, dans une première section conductrice, une valeur et/ou une direction d'une torsion d'une deuxième section conductrice est mesurée par l'intermédiaire de la tension mesurable.
